# EUROPÄISCHE PATENTSCHRIFT

(11) **EP 3 929 594 B1**
(45) Veröffentlichungstag und Bekanntmachung des Hinweises auf die Patenterteilung: **01.05.2024**
(21) Anmeldenummer: 21000135.0
(22) Anmeldetag: 14.05.2021
(51) Int. Cl.: H01C 1/16, G01R 1/20, G01R 3/00, H01C 1/14

(54) **VERFAHREN ZUR HERSTELLUNG EINER VORRICHTUNG ZUR MESSUNG VON STROMSTÄRKEN UND VORRICHTUNG ZUR MESSUNG VON STROMSTÄRKEN**
DEVICE FOR MEASURING CURRENT INTENSITIES AND METHOD FOR MANUFACTURING A DEVICE FOR MEASURING CURRENT INTENSITIES
PROCÉDÉ DE FABRICATION D'UN DISPOSITIF DE MESURE DES NIVEAUX DE COURANT ET DISPOSITIF DE MESURE DES NIVEAUX DE COURANT

(30) Priorität: 09.06.2020 DE 102020003458
(43) Veröffentlichungstag der Anmeldung: 29.12.2021
(73) Patentinhaber: Wieland-Werke AG, 89079 Ulm (DE)
(72) Erfinder: Thumm, Gerhard, 89155 Erbach (DE); Voggeser, Volker, 89250 Senden (DE); Wolf, Michael, 89077 Ulm (DE)

(56) Entgegenhaltungen:
- DE-A1-102006 019 895
- DE-A1-102007 033 182
- DE-A1-102011 106 187
- DE-A1-102013 200 580
- DE-A1-102014 207 759

## Beschreibung

Die Erfindung betrifft ein Verfahren zur Herstellung einer Vorrichtung zur Messung von Stromstärken und eine solche Vorrichtung.

Für die Strommessung in elektronischen Schaltungen werden Messwiderstände verwendet, die in Reihe zu dem zu überwachenden Bauteil geschaltet sind. Dabei wird die Stromstärke aus der über den als Shunt-Widerstand bezeichneten Messwiderstand abfallenden Spannung bestimmt. Die korrekte und verlässliche Messung der Stromstärke ist beispielsweise besonders wichtig in einem Batteriemanagementsystem eines Elektro- oder Hybridfahrzeugs. Eine Widerstandsanordnung, die einen solchen niederohmigen Messwiderstand mit ungefähr 10 bis 50 µOhm sowie Anschlusselemente zum Verbinden der Widerstandsanordnung mit dem Stromkreis umfasst, kann aus einem längsnahtgeschweißten Verbundmaterial hergestellt werden. Dies ist beispielsweise aus der Druckschrift EP 0 605 800 A1 bekannt. Das Verbundmaterial wird aus drei Metallbändern hergestellt, indem die einzelnen Metallbänder jeweils über eine Längsnaht miteinander durch ein Elektronenstrahl- oder Laserschweißverfahren verbunden werden.

Die über einem Messwiderstand abfallende Spannung wird über Kontaktstifte oder ähnliche Elemente, die beidseitig vom Messwiderstand auf den Anschlusselementen angeordnet sind, abgegriffen. Solche Kontaktstifte können auf den Anschlusselementen der Widerstandsanordnung aufgelötet, aufgepresst oder aufgeschweißt sein. Die Spannung wird von einer Mess- und Auswerteelektronik erfasst und weiterverarbeitet. Hierfür sind elektronische Bauteile vorgesehen, die auf einer Leiterplatte angeordnet sein können. Die Leiterplatte kann sich dabei in unmittelbarer Nähe der Widerstandsanordnung befinden.

Aus der Druckschrift DE 10 2009 031 408 A1 ist eine Widerstandsanordnung mit einem niederohmigen Strommesswiderstand bekannt. Bei dieser Widerstandsanordnung sind zum Abgriff der Spannung Anschlusskontakte vorgesehen, die durch Ausprägung und Gewindeformung in den plattenförmigen Teilstücken, die zum Anschluss der Widerstandsanordnung an den äußeren Stromkreis dienen, gebildet sind. Der Anschluss der Messleitungen zur Spannungsmessung an die Anschlusskontakte erfolgt mittels Kabelschuhen und Befestigungsschrauben.

Des Weiteren ist aus der Druckschrift US 10 163 553 B2 eine Widerstandsanordnung mit zwei plattenförmigen Elementen zum Anschluss der Widerstandsanordnung an einen äußeren Stromkreis und einem streifenförmigen Widerstandselement bekannt. Beidseitig des Widerstandselements ist in den beiden Anschlusselementen jeweils ein Loch vorhanden, in das jeweils ein Kontaktstift gesteckt wird. Die Kontaktstifte sind separate Bauteile, die eigens hergestellt und zu der Widerstandsanordnung hinzugefügt werden müssen.

Die Druckschrift DE 10 2007 033 182 A1 offenbart ein Widerstandselement mit Anschlussstücken und einem Widerstandsstück. Kontakte werden gebildet werden, indem ein Draht mit gebogenen Enden auf die Anschlussstücke aufgelegt und mit der Oberfläche der Anschlussstücke stoffschlüssig, beispielsweise durch Ultraschallschweißen, verbunden wird.

Bei den aus dem Stand der Technik bekannten Vorrichtungen ist es notwendig, zusätzliche Bauteile zu verwenden, um die über dem Messwiderstand abfallende Spannung abzugreifen. Dies erfordert zusätzlichen Aufwand und Kosten. Ferner können an den Kontaktstellen der einzelnen Bauteile Kontaktspannungen auftreten, die das Spannungssignal verfälschen können.

Der Erfindung liegt die Aufgabe zugrunde, ein verbessertes, insbesondere einfacheres und kostengünstigeres Verfahren zur Herstellung einer Vorrichtung zur Messung von Stromstärken und eine solche Vorrichtung anzugeben.

Die Erfindung wird bezüglich eines Verfahrens durch die Merkmale des Anspruchs 1 und bezüglich einer Vorrichtung durch die Merkmale des Anspruchs 8 wiedergegeben. Die weiteren, rückbezogenen Ansprüche betreffen vorteilhafte Aus- und Weiterbildungen der Erfindung.

Die Erfindung schließt ein Verfahren zur Herstellung einer Vorrichtung zur Messung von Stromstärken mittels einer Widerstandsanordnung ein, wobei das Verfahren folgende Schritte umfasst:
a) Bereitstellen einer Widerstandsanordnung umfassend mindestens zwei Anschlusselemente und mindestens ein in Bezug auf die Richtung des Stromflusses zwischen den Anschlusselementen angeordnetes Widerstandselement, wobei das mindestens eine Widerstandselement einerseits und die Anschlusselemente andererseits aus unterschiedlichen, elektrisch leitenden Materialien bestehen,
b) Formen mindestens eines Kontaktstifts aus dem Material mindestens eines Anschlusselements,
c) Positionieren einer Leiterplatte, welche mindestens eine Leiterbahn und mindestens eine Durchgangsbohrung aufweist, auf der Widerstandsanordnung derart, dass der mindestens eine Kontaktstift durch die Durchgangsbohrung hindurch ragt und auf der der Widerstandsanordnung abgewandten Seite der Leiterplatte einen Überstand über die Leiterplatte aufweist,
d) Laterales Verbreitern des Kontaktstifts zumindest im Bereich seines Überstands durch Verformung des Materials, so dass die Leiterplatte auf der Widerstandsanordnung mechanisch fixiert wird,
e) Herstellen einer elektrisch leitenden Verbindung zwischen dem Kontaktstift und mindestens einer Leiterbahn der Leiterplatte.

Unter der Messung von Stromstärken wird auch die Messung der Stärke eines zeitlich sich möglicherweise verändernden elektrischen Stroms verstanden. Die vorstehend beschriebene Widerstandsanordnung kann einen niederohmigen Shunt-Widerstand als Widerstandselement umfassen. Die Anschlusselemente der Widerstandsanordnung können aus Kupfer, einer bevorzugt niedriglegierten Kupferlegierung, aus Aluminium oder einer bevorzugt niedriglegierten Aluminiumlegierung sein oder mindestens einen dieser Werkstoffe umfassen. Das Widerstandselement kann aus einer Kupferlegierung sein, die als Widerstandslegierung üblicherweise verwendet wird. Der spezifische elektrische Widerstand der Widerstandslegierung ist deutlich größer als der spezifische elektrische Widerstand des Materials der Anschlusselemente. Die Anschlusselemente können endständige Anschlusselemente der Widerstandsanordnung sein. Es ist aber auch möglich, dass mindestens ein Anschlusselement in Bezug auf einen möglichen Strompfad zwischen zwei Widerstandselementen angeordnet ist. Die Widerstandsanordnung kann in planarer Anordnung ausgebildet sein. Dabei sind die Anschlusselemente und das mindestens eine Widerstandselement als platten- oder streifenförmige Elemente gebildet und in einer Ebene nebeneinander, bevorzugt in einer Reihe, angeordnet. Die Dicke des Widerstandselements beziehungsweise der Widerstandselemente kann dabei beliebig sein. Üblicherweise ist sie aber nicht größer als die Dicke der Anschlusselemente.

Die Leiterplatte weist mindestens eine Leiterbahn auf, die bevorzugt auf der von der Widerstandanordnung abgewandten Seite der Leiterplatte angeordnet ist. Ferner können auf der Leiterplatte elektrische Bauteile angeordnet sein, die zur Messung und Auswertung von elektrischen Signalen dienen. Mit dem Begriff Durchgangsbohrung wird eine Aussparung in der Leiterplatte bezeichnet, die sich über die gesamte Dicke der Leiterplatte erstreckt.

Unter Kontaktstift wird ein Werkstoffvorsprung verstanden, der sich über die sonst unverformte Oberfläche eines Anschlusselements erhebt. Das Formen des Kontaktstifts erfolgt durch Verlagern von Material eines Anschlusselements im Wesentlichen in Richtung senkrecht zur Oberfläche des Anschlusselements. Die Richtung, in der das Material verlagert wird, definiert die Achse des Kontaktstifts. Der Kontaktstift kann massiv, teilweise hohl oder entlang seiner gesamten Achse hohl sein. Die Querschnittsform des Kontaktstifts kann beliebig sein, bevorzugt kreisförmig, rechteckig, quadratisch oder sechseckig bei einem massiven Kontaktstift oder ringförmig bei einem hohlen Kontaktstift. Form und/oder Größe des Querschnitts des Kontaktstifts können konstant sein oder sich entlang der Erstreckung des Kontaktstifts stetig oder unstetig verändern. Beispielsweise kann ein Kontaktstift eine leicht konische Kontur, also eine Kontur mit bezogen auf die Oberfläche des Anschlusselements leicht geneigten Begrenzungsflächen aufweisen. Ferner kann der Kontaktstift einen Absatz aufweisen. Unter einem Absatz wird eine unstetige, also sprungartige Veränderung der Querschnittsform und/oder der Querschnittsgröße des Kontaktstifts verstanden. Die Höhe des Kontaktstifts bezogen auf die unverformte Oberfläche des Anschlusselements ist größer als die Dicke der Leiterplatte. Folglich weist der Kontaktstift einen Überstand über die Leiterplatte auf, wenn die Leiterplatte so auf der Widerstandsanordnung positioniert wird, dass der Kontaktstift durch die Durchgangsbohrung hindurch und über sie hinaus ragt.

Der Kontaktstift kann, bevorzugt zusammen mit einem weiteren Kontaktstift, als Spannungsabgriff zur Messung der über mindestens einem Widerstandselement abfallenden elektrischen Spannung verwendet werden. Alternativ kann der Kontaktstift auch zur Erdung der Widerstandsanordnung dienen. Bevorzugt werden in allen Anschlusselementen der Widerstandsanordnung ein oder mehrere solcher Kontaktstifte geformt. Dabei werden die Kontaktstifte, die zur Spannungsmessung dienen, möglichst nahe an dem Widerstandselement positioniert, an dem der Spannungsabfall ermittelt werden soll.

Das laterale Verbreitern des Kontaktstifts in Verfahrensschritt d) bezeichnet ein Verformen des Kontaktstifts durch Verlagern von Material senkrecht zur Achse des Kontaktstifts, also ein - bezogen auf die Achse - radiales Verlagern. Dieses Verformen erfolgt in größerer Ausprägung im dem Bereich des Kontaktstifts, der über die Leiterplatte hinausragt. In diesem Bereich ist die laterale Erstreckung des verlagerten Materials nach Verfahrensschritt d) zumindest lokal größer als die Weite der Durchgangsbohrung. Durch ein solches Verformen des Kontaktstifts wird die Leiterplatte auf der Widerstandsanordnung fixiert. Insbesondere kann der Kontaktstift durch das laterale Verbreitern seines über die Leiterplatte überstehenden Abschnitts eine Form ähnlich der eines Pilzes oder eines Nagels im Bereich des Nagelkopfes erhalten. Der Querschnitt des Kontaktstifts in axialer Richtung kann insbesondere T-förmig sein.

In geringerer Ausprägung erfolgt das laterale Verbreitern des Kontaktstifts auch in dem Bereich, der sich innerhalb der Durchgangsbohrung der Leiterplatte befindet. In diesem Bereich wird die laterale Verbreiterung durch die Innenwand der Durchgangsbohrung begrenzt.

Der besondere Vorteil des beschriebenen Verfahrens besteht darin, dass zur Herstellung der Verbindung zwischen Widerstandsanordnung und Leiterplatte keine zusätzlichen Bauteile und/oder Materialien benötigt werden. Weil der Kontaktstift direkt aus dem Material eines Anschlusselements geformt wird, ist es nicht erforderlich, ihn separat auf der Widerstandsanordnung oder auf der Leiterplatte zu montieren. Es entfallen die hierfür notwendigen Arbeitsschritte und die benötigten Materialien, wie beispielsweise Lot. Mehrere Kontaktstifte können gleichzeitig geformt werden. Durch die monolithische Verbindung zwischen Anschlusselement und Kontaktstift werden unerwünschte Kontaktspannungen, die eine Messung verfälschen können, vermieden.

Wird die Widerstandsanordnung hergestellt, indem sie aus einem längsnahtgeschweißten, bandförmigen Verbundmaterial abgelängt wird, dann können die Kontaktstifte gleichzeitig mit dem Ablängen des Verbundmaterials geformt werden. Die Schritte a) und b) des Verfahrens erfolgen in diesem Fall also gleichzeitig. Ein separater, zusätzlicher Arbeitsschritt für das Formen der Kontaktstifte ist somit nicht notwendig. Das Verfahren wird somit schneller und kostengünstiger als wenn die Kontaktstifte erst nach dem Ablängen des Verbundmaterials geformt werden. Ferner wird auf diese Weise eine hohe Positionsgenauigkeit der Kontaktstifte erreicht.

Im Rahmen einer bevorzugten Ausführungsform der Erfindung kann das Formen des Kontaktstifts in Verfahrensschritt b) durch einen Prägeschritt oder durch Fließpressen erfolgen. Prägen und Fließpressen eignen sich besonders zur Formung von monolithisch mit dem Material der Anschlusselemente verbundenen Kontaktstiften, die sich im Wesentlichen senkrecht zur Oberfläche der Anschlusselemente erstrecken. Das Formen des Materials erfolgt dabei mittels eines Stempels.

Im Rahmen einer speziellen Ausgestaltung dieser Ausführungsform der Erfindung kann zur Formgebung des Kontaktstifts eine Negativform mit mindestens einer der Kontur des Kontaktstifts entsprechenden Aussparung verwendet werden. Durch eine solche Negativform kann die äußere Kontur des Kontaktstifts bestimmt werden.

Im Rahmen einer weiteren bevorzugten Ausführungsform der Erfindung kann das laterale Verbreitern des Kontaktstifts in Verfahrensschritt d) durch einen Stauchvorgang, durch Prägen, durch Verstemmen (caulking) oder durch Umbördeln (flanging) erfolgen. Umbördeln kommt dabei bevorzugt bei einem entlang seiner gesamten Achse hohlen Kontaktstift zur Anwendung, während die anderen Verfahren bei einem massiven oder nur teilweise hohlen Kontaktstift bevorzugt verwendet werden. Bei diesen Verfahren wird die Kraft, die zur lateralen Verformung notwendig ist, in Richtung der Achse des Kontaktstifts eingeleitet. Somit wird das Material des Kontaktstifts nicht nur lateral verbreitert, sondern auch in Richtung seiner Achse auf die Leiterplatte gepresst. Deshalb eignen sich die genannten Verfahren besonders gut, den über die Leiterplatte hinaus ragenden Teil des Kontaktstifts in alle oder nur in bestimmte Richtungen senkrecht zur Achse des Kontaktstifts zu verbreitern und gleichzeitig eine gute mechanische Fixierung der Leiterplatte auf der Widerstandsanordnung zu erzielen.

Im Rahmen einer speziellen Ausgestaltung der Erfindung kann das laterale Verbreitern des Kontaktstifts in Verfahrensschritt d) durch Erwärmen des Materials mittels Ultraschall oder mittels eines Lasers unterstützt werden. Das Material des Kontaktstifts ist aufgrund der Verformung in Verfahrensschritt b) sehr verfestigt und hart. Dies ist für die nachfolgende Verformung in Schritt d) hinderlich. Durch den Eintrag von Wärme mittels eines Lasers oder mittels Ultraschall kann das Material des Kontaktstifts soweit erwärmt werden, dass es sich zumindest teilweise entfestigt, also weicher wird. Das Verformen in Schritt d) ist dann leichter möglich.

Vorteilhafterweise kann das Herstellen der elektrisch leitenden Verbindung in Verfahrensschritt e) durch das laterale Verbreitern des Kontaktstifts im Bereich seines Überstands in Verfahrensschritt d) erfolgen. Durch das Verformen des Kontaktstifts in Schritt d) wird eine kraftschlüssige Verbindung zwischen der Leiterplatte und dem Kontaktstift hergestellt. Dabei ist vorteilhafterweise ferner vorgesehen, dass der verbreiterte Bereich des Kontaktstifts in Kontakt mit mindestens einer Leiterbahn kommt, die sich auf der von der Widerstandsanordnung abgewandten Oberfläche der Leiterplatte befindet. Die kraftschlüssige Verbindung zwischen der Leiterplatte und dem Kontaktstift führt dann auch zu einer elektrischen Verbindung zwischen dem Kontaktstift und der Leiterbahn.

Im Rahmen einer zusätzlichen Ausführungsform der Erfindung kann das Herstellen der elektrisch leitenden Verbindung in Verfahrensschritt e) erfolgen, indem der Kontaktstift derart verformt wird, dass er die Innenoberfläche der Durchgangsbohrung der Leiterplatte kontaktiert. Hierbei weist die Innenoberfläche der Durchgangsbohrung ein elektrisch leitendes Material auf, das mit mindestens einer Leiterbahn der Leiterplatte in Verbindung steht. Durch das laterale Verbreitern des Kontaktstifts in Schritt d) kommt es zu einer kraftschlüssigen Verbindung zwischen dem Kontaktstift und der Innenseite der Durchgangsbohrung, beispielsweise in der Art einer Presspassung. Auf diese Weise kann ein besonders guter elektrischer Kontakt zwischen dem Kontaktstift und der Leiterbahn hergestellt werden.

Hinsichtlich weiterer technischer Merkmale und Vorteile des erfindungsgemäßen Verfahrens wird hiermit explizit auf die nachstehenden Erläuterungen im Zusammenhang mit der erfindungsgemäßen Vorrichtung sowie auf die Figuren und die Figurenbeschreibung verwiesen.

Ein weiterer Aspekt der Erfindung schließt eine Vorrichtung zur Messung von Stromstärken ein. Hierunter wird auch die Messung der Stärke eines zeitlich sich möglicherweise verändernden elektrischen Stroms verstanden. Die Vorrichtung umfasst eine Widerstandsanordnung und eine mit der Widerstandsanordnung mechanisch und elektrisch verbundene Leiterplatte. Die Widerstandsanordnung umfasst mindestens zwei Anschlusselemente und mindestens ein in Bezug auf die Richtung des Stromflusses zwischen den Anschlusselementen angeordnetes Widerstandselement, wobei das mindestens eine Widerstandselement einerseits und die Anschlusselemente andererseits aus unterschiedlichen, elektrisch leitenden Materialien bestehen. Die Leiterplatte weist mindestens eine Durchgangsbohrung auf. Ferner weist die Leiterplatte mindestens eine Leiterbahn auf, die bevorzugt auf der von der Widerstandsanordnung abgewandten Seite der Leiterplatte angeordnet ist. Gemäß der Erfindung weist die Widerstandsanordnung mindestens einen monolithisch mit einem der Anschlusselemente verbundenen und aus dem Material des Anschlusselements herausgearbeiteten Kontaktstift auf, durch den die Widerstandsanordnung mit der Leiterplatte verbunden ist, indem sich der Kontaktstift durch die Durchgangsbohrung der Leiterplatte hindurch erstreckt, über sie hinaus ragt und auf der von der Widerstandsanordnung abgewandten Seite der Leiterplatte eine laterale Verbreiterung aufweist, durch welche die Leiterplatte auf der Widerstandsanordnung mechanisch fixiert ist.

Hinsichtlich der zur Beschreibung der Vorrichtung verwendeten Begriffe wird hiermit explizit auf die vorstehenden Erläuterungen der Begriffe im Zusammenhang mit der Beschreibung des Verfahrens zur Herstellung einer solchen Vorrichtung verwiesen.

Der besondere Vorteil der beschriebenen Vorrichtung besteht darin, dass durch die monolithische Verbindung zwischen Anschlusselement und Kontaktstift unerwünschte Kontaktspannungen, die eine Messung verfälschen können, vermieden werden. Ferner kann die Vorrichtung kostengünstig und mit hoher Präzision hergestellt werden, denn der Kontaktstift ist unmittelbar aus dem Material des Anschlusselements herausgeformt.

Im Rahmen einer Ausführungsform der Vorrichtung kann der mindestens eine Kontaktstift mittels seiner lateralen Verbreiterung in elektrischem Kontakt mit mindestens einer Leiterbahn der Leiterplatte stehen. Die mechanische Fixierung der Leiterplatte auf der Widerstandsanordnung und die elektrische Kontaktierung dieser Komponenten erfolgen dann durch den Kontaktstift.

Im Rahmen einer weiteren Ausführungsform der Vorrichtung kann der mindestens eine Kontaktstift in elektrischem Kontakt mit der Innenoberfläche der Durchgangsbohrung der Leiterplatte stehen.

Im Rahmen einer weiteren vorteilhaften Ausführungsform der Vorrichtung kann der mindestens eine Kontaktstift einen Absatz aufweisen, auf dem die Leiterplatte in einer Weise aufliegt, dass die Leiterplatte von dem Anschlusselement und somit von der Widerstandsanordnung beabstandet ist. Der Abstand zwischen der Leiterplatte und der Widerstandsanordnung bewirkt eine bessere thermische Entkopplung der Leiterplatte von der Widerstandsanordnung. Die Wärme, die bei Stromdurchfluss durch das Widerstandselement entsteht, kann in diesem Fall nicht direkt vom Widerstandselement oder von einem Anschlusselement auf die Leiterplatte übertragen werden, sondern die Wärme muss durch den Kontaktstift strömen. Aufgrund seines relativ kleinen Querschnitts stellt der Kontaktstift einen großen Wärmewiderstand dar. Der Wärmestrom von der Widerstandsanordnung zur Leiterplatte wird deshalb reduziert und die Leiterplatte bleibt auf einem niedrigeren Temperaturniveau als wenn die Leiterplatte direkt auf einem Anschlusselement aufliegen würde. Diese Ausführungsform ist besonders dann vorteilhaft, wenn die Dicke des Widerstandselements nicht kleiner als die Dicke der Anschlusselemente ist.

In vorteilhafter Ausgestaltung der Erfindung kann die Oberfläche des mindestens einen Kontaktstifts eine metallische Beschichtung, insbesondere eine zinn-, silber- oder nickelhaltige Beschichtung, aufweisen. Eine solche Beschichtung verhindert Korrosion und kann somit dafür sorgen, dass der elektrische Kontakt zwischen dem Kontaktstift und der Leiterbahn über die gesamte Lebensdauer der Vorrichtung von hoher Güte ist. Die Beschichtung kann dabei vor dem Formen des Kontaktstifts in Schritt b) aufgebracht worden sein oder der Kontaktstift kann in einem separaten Schritt zwischen den Verfahrensschritten b) und c) beschichtet worden sein.

Hinsichtlich weiterer technischer Merkmale und Vorteile der erfindungsgemäßen Vorrichtung wird hiermit explizit auf die Erläuterungen im Zusammenhang mit dem vorstehend beschriebenen erfindungsgemäßen Verfahren sowie auf die Figuren und die Figurenbeschreibung verwiesen.

Ausführungsbeispiele der Erfindung werden anhand der schematischen Zeichnungen näher erläutert.

Darin zeigen:
- Fig. 1: eine Schrägansicht einer Widerstandsanordnung
- Fig. 2: eine Seitenansicht einer Widerstandsanordnung
- Fig. 3: eine Widerstandsanordnung bei Abschluss von Verfahrensschritt b)
- Fig. 4: eine Widerstandsanordnung mit geformten Kontaktstiften
- Fig. 5: eine Widerstandsanordnung mit darauf positionierter Leiterplatte
- Fig. 6: eine Widerstandsanordnung mit darauf fixierter Leiterplatte
- Fig. 7: eine Vorrichtung mit Kontaktstiften mit Absatz
- Fig. 8: eine Vorrichtung mit hohlen Kontaktstiften

Einander entsprechende Teile sind in allen Figuren mit denselben Bezugszeichen versehen.

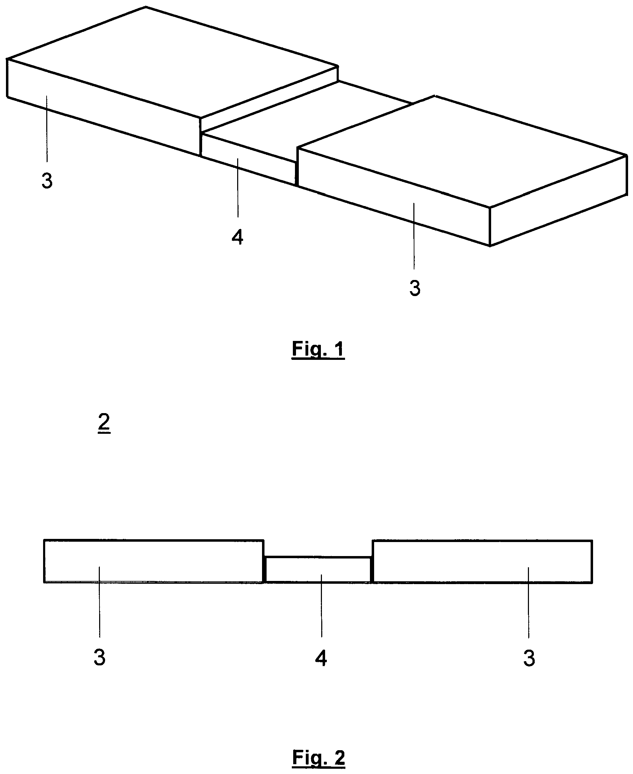

Fig. 1 zeigt eine Schrägansicht einer Widerstandsanordnung 2 ohne einen Kontaktstift. Die Widerstandsanordnung 2 weist zwei endständige Anschlusselemente 3 und ein Widerstandselement 4 auf, welches zwischen den beiden Anschlusselementen 3 positioniert ist. Die Anschlusselemente 3 und das Widerstandselement 4 haben jeweils eine plattenförmige Form. Die Dicke des Widerstandselements 4 ist etwas geringer als die Dicke der beiden Anschlusselemente 3. Die Widerstandsanordnung 2 kann an den beiden Anschlusselementen 3 mit einem Stromkreis verbunden werden. Zu diesem Zweck können die beiden Anschlusselemente 3 nicht dargestellte Verbindungsvorrichtungen aufweisen, beispielsweise Bohrungen. Diese Verbindungsvorrichtungen sind jeweils in dem Bereich der Anschlusselemente 3 angebracht, der vom Widerstandselement 4 entfernt ist. Das Widerstandselement 4 befindet sich bezogen auf die Richtung des Stromflusses zwischen den Anschlusselementen 3. Bei Stromfluss fällt über dem Widerstandselement 4 eine elektrische Spannung ab, anhand derer die Stärke des durch die Widerstandsanordnung 2 fließenden Stroms ermittelt werden kann.

Fig. 2 zeigt eine Seitenansicht einer Widerstandsanordnung 2 gemäß Fig. 1. Eine Widerstandsanordnung 2 wie in Figuren 1 und 2 dargestellt kann in bekannter Weise durch Längsnahtschweißen von drei Bändern zu einem Verbundmaterial und anschließendes Ablängen des geschweißten Verbundmaterials hergestellt werden.

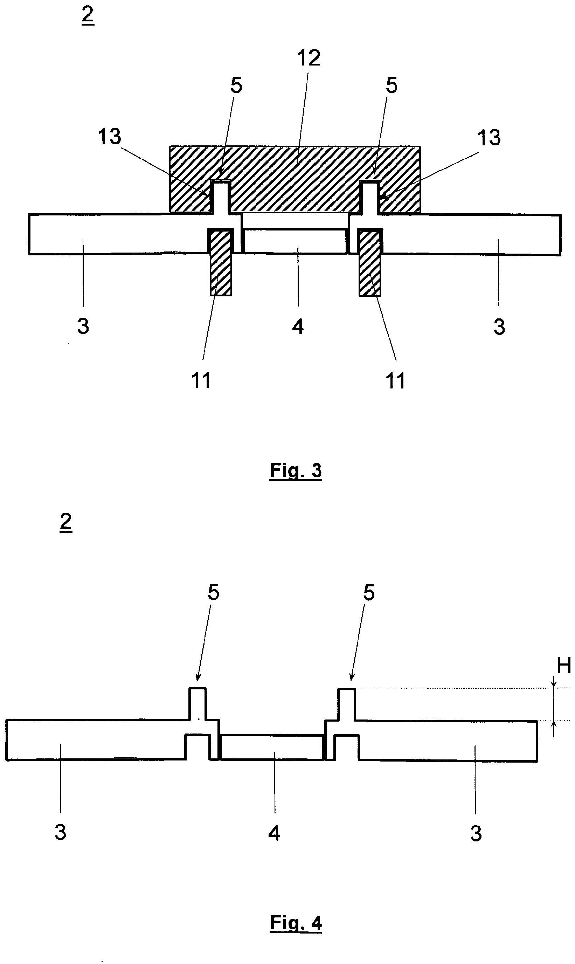

Fig. 3 zeigt die Widerstandsanordnung 2 gemäß Fig. 1 und 2 bei Abschluss von Verfahrensschritt b). Auf der Oberseite der Widerstandsanordnung 2 wurde eine Negativform 12 mit zwei Aussparungen 13 positioniert. Auf der Unterseite der Widerstandsanordnung 2 sind zwei Stempel 11 in das Material der beiden Anschlusselemente 3 eingedrungen. Die Stempel 11 sind so positioniert, dass sie den Aussparungen 13 der Negativform 12 gegenüberliegen. Durch das Eindringen der Stempel 11 wurde Material der Anschlusselemente 3 senkrecht zur Oberfläche der Anschlusselemente 3 verdrängt und in die Aussparungen 13 der Negativform 12 verlagert. Auf diese Weise wurden zwei Werkstoffvorsprünge geformt, die Kontaktstifte 5 bilden. Die Kontaktstifte 5 sind im dargestellten Fall massiv ausgeführt.

Fig. 4 zeigt die Widerstandsanordnung 2 mit zwei geformten Kontaktstiften 5 nach Verfahrensschritt b). Die Stempel 11 und die Negativform 12 wurden entfernt. Um das Entfernen von Stempel 11 und Negativform 12 zu erleichtern, können die Stempel 11 und die Aussparungen 13 in der Negativform 12 jeweils eine Kontur mit Schrägen zur Entformung aufweisen. Dementsprechend können die geformten Kontaktstifte 5 ebenfalls eine Kontur mit Schrägen aufweisen. Der Winkel, den die Schrägen zur Entformung mit der Normalen auf die Oberfläche der Anschlusselemente 3 einschließen, beträgt typischerweise ungefähr 2°. Aufgrund dieser geringen Abweichung von der Normalen sind die Schrägen in den Figuren nicht explizit dargestellt. Die Höhe der Kontaktstifte 5 ist mit dem Symbol H gekennzeichnet. Die Kontaktstifte 5 sind zum Abgreifen der über dem Widerstandselement 4 abfallenden elektrischen Spannung vorgesehen. Um Verfälschungen des Messwerts zu minimieren, wurden die Kontaktstifte 5 so aus den Anschlusselementen 3 geformt, dass sie nahe an der Verbindungsstelle zwischen dem jeweiligen Anschlusselement 3 und dem Widerstandselement 4 positioniert sind.

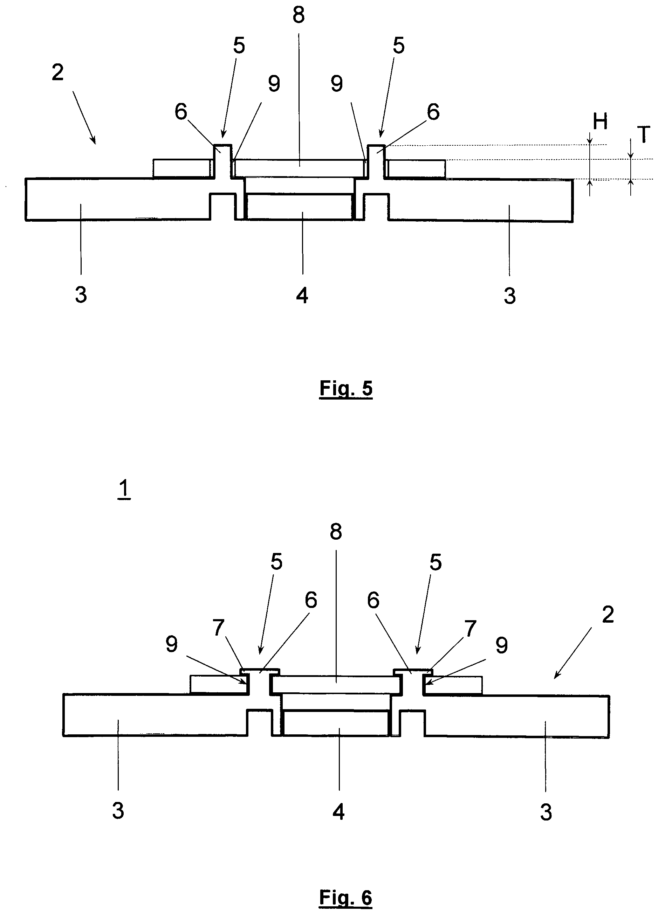

Fig. 5 zeigt die Widerstandsanordnung 2 mit zwei geformten Kontaktstiften 5 und einer auf der Widerstandsanordnung 2 positionierten Leiterplatte 8. Fig. 5 stellt somit die Widerstandsanordnung 2 und die Leiterplatte 8 nach Verfahrensschritt c) dar. Die Leiterplatte 8 weist zwei Durchgangsbohrungen 9 auf. Die Leiterplatte 8 wurde so positioniert, dass die Kontaktstifte 5 durch die Durchgangsbohrungen 9 hindurch ragen. Die Höhe H der Kontaktstifte 5 ist größer als die Dicke T der Leiterplatte 8, so dass die Kontaktstifte 5 auf der der Widerstandsanordnung 2 abgewandten Seite der Leiterplatte 8 jeweils einen Überstand 6 über die Leiterplatte 8 aufweisen. Die lichte Weite der Durchgangsbohrungen 9 ist geringfügig größer als die äußere Abmessung der Kontaktstifte 5.

Fig. 6 zeigt eine Vorrichtung 1 zur Messung von Stromstärken mit einer Widerstandsanordnung 2 und einer auf der Widerstandsanordnung 2 fixierten Leiterplatte 8. Die Fig. 6 zeigt die Vorrichtung 1 nach Verfahrensschritt e). Die beiden Kontaktstifte 5 der Widerstandsanordnung 2 wurden so verformt, dass sie die Leiterplatte 8 auf der Widerstandsanordnung 2 mechanisch fixieren und gleichzeitig jeweils einen elektrischen Kontakt mit jeweils einer Leiterbahn der Leiterplatte 8 bilden. Hierzu wurden die Kontaktstifte 5 sowohl im Bereich ihres Überstands 6 über die Leiterplatte 8 als auch in dem Bereich, der sich innerhalb der Durchgangsbohrung 9 der Leiterplatte 8 befindet, lateral verbreitert. Im Bereich der Durchgangsbohrung 9 wird die laterale Verbreiterung durch die Innenwand der Durchgangsbohrung 9 begrenzt. Die Kontaktstifte 5 füllen die jeweilige Durchgangsbohrung 9 formschlüssig aus. Im Bereich des Überstands 6 erfolgt die Verformung soweit, dass jeweils eine laterale Verbreiterung 7 gebildet wird, die sich weiter erstreckt als die Weite der jeweiligen Durchgangsbohrung 9. Somit erhalten die Kontaktstifte 5 eine Form mit einem T-förmigen Querschnitt in axialer Richtung. Dadurch wird die Leiterplatte 8 kraftschlüssig auf der Widerstandsanordnung 2 fixiert. Gleichzeitig kontaktiert die laterale Verbreiterung 7 jedes Kontaktstifts 5 jeweils mindestens eine Leiterbahn auf der von der Widerstandsanordnung 2 abgewandten Seite der Leiterplatte 8. Somit werden elektrische Verbindungen zwischen der Widerstandsanordnung 2 und der Leiterplatte 8 hergestellt. Die Leiterbahnen sind mit nicht dargestellten, elektronischen Bauelementen verbunden, mittels derer die über dem Widerstandselement 4 abfallende Spannung ermittelt werden kann.

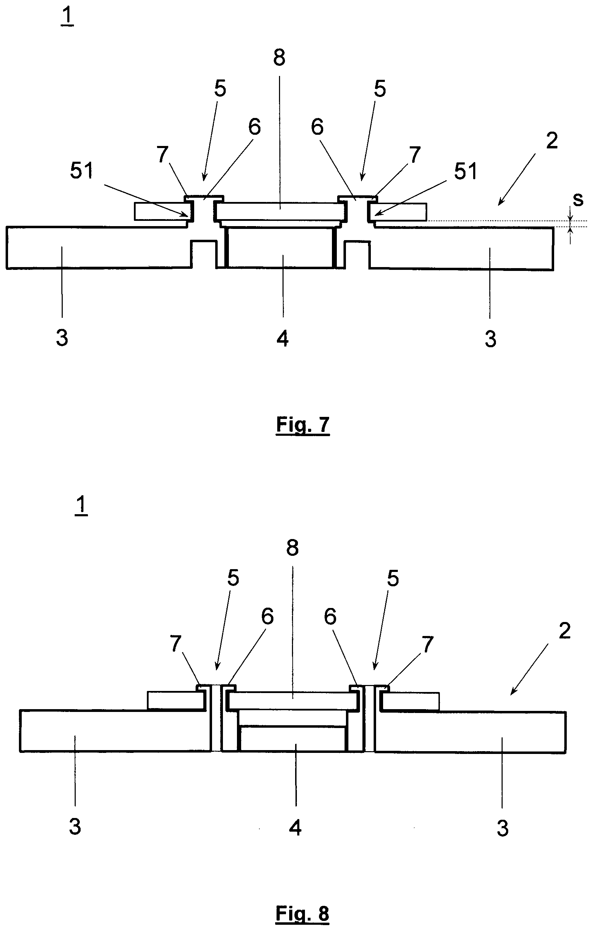

Fig. 7 zeigt eine zeigt ein weiteres Ausführungsbeispiel einer Vorrichtung 1 zur Messung von Stromstärken mit einer Widerstandsanordnung 2 und einer auf der Widerstandsanordnung 2 fixierten Leiterplatte 8. In dem in Fig. 7 dargestellten Ausführungsbeispiel ist die Dicke des Widerstandselements 4 ungefähr gleich der Dicke der Anschlusselemente 3. Die Kontaktstifte 5 weisen jeweils einen um den Kontaktstift 5 umlaufenden Absatz 51 auf, auf dem die Leiterplatte 8 aufliegt. Zu diesem Zweck sind die Kontaktstifte 5 so gestaltet, dass die äußere Abmessung der Kontaktstifte 5 in dem Teilbereich des jeweiligen Kontaktstifts 5, der unmittelbar an ein Anschlusselement 3 angrenzt, jeweils größer als die lichte Weite der jeweiligen Durchgangsbohrung 9 der Leiterplatte 8 ist. Somit liegt die Leiterplatte 8 weder direkt auf den Anschlusselementen 3 noch auf dem Widerstandselement 4 auf, sondern sie weist zu den Anschlusselementen 3, zum Widerstandselement 4 und somit zu der gesamten Widerstandanordnung 2 einen Abstand s auf. Damit ist die Leiterplatte von der Widerstandsanordnung thermisch besser entkoppelt. Bei der Formung der Kontaktstifte 5 aus dem Material des jeweiligen Anschlusselements 3 wurde die Höhe des jeweiligen Absatzes 51 bereits berücksichtigt. Die Fixierung und Kontaktierung der Leiterplatte 8 durch die Kontaktstifte 5 erfolgt analog zu dem in Fig. 6 dargestellten und im Zusammenhang mit Fig. 6 erläuterten Ausführungsbeispiel.

Fig. 8 zeigt eine zeigt als weiteres Ausführungsbeispiel eine Vorrichtung 1 zur Messung von Stromstärken mit einer Widerstandsanordnung 2 und einer auf der Widerstandsanordnung 2 fixierten Leiterplatte 8, wobei die Kontaktstifte 5 jeweils über ihre gesamte Erstreckung hohl ausgeführt sind. Um jeweils eine laterale Verbreiterung 7 zur Fixierung der Leiterplatte 8 zu erzeugen, wurden die Kontaktstifte 5 im Bereich ihres Überstands 7 umgebördelt. Die Kontaktstifte 5 haben eine Form ähnlich der eines Hohlnietes. Bei dem in Fig. 8 dargestellten Ausführungsbeispiel der Vorrichtung 1 liegt die Leiterplatte 8 auf den beiden Anschlusselementen 3 auf. Alternativ wäre es auch möglich, die hohlen Kontaktstifte 5 mit einem Absatz 51 auszuführen, ähnlich den Kontaktstiften 5, die in Fig. 7 dargestellt sind, so dass die Leiterplatte 8 von den Anschlusselementen 3 beabstandet ist.

Aus Gründen der besseren Darstellbarkeit wurde die Erfindung in Figuren 1 bis 8 exemplarisch anhand von Widerstandsanordnungen 2 erläutert, die jeweils lediglich ein Widerstandselement 4 und zwei endständige Anschlusselemente 3 umfassen. Es ist auch möglich, das vorstehend beschriebene Verfahren auf Widerstandsanordnungen anzuwenden, die zwei oder mehr Widerstandselemente 4 sowie mindestens ein weiteres, in Bezug auf einen möglichen Strompfad zwischen zwei Widerstandselementen 4 angeordnetes Anschlusselement 3 aufweisen. Die Widerstandsanordnung kann dabei so konfiguriert sein, dass durch mindestens zwei Widerstandselemente 4 der gleiche Strom fließt, was eine redundante Strommessung ermöglicht, oder dass durch mindestens zwei Widerstandselemente 4 verschiedene Ströme fließen, was die Messung von Teilströmen ermöglicht. Das anhand der vorstehenden Beschreibung, anhand der Figuren 1 bis 8 und anhand der Ausführungsbeispiele erläuterte Verfahren zur Formung von Kontaktstiften 5 und zur Herstellung einer mechanischen und elektrischen Verbindung mit einer Leiterplatte 8 kann in diesen Fällen auch zur Formung von einem oder mehreren Kontaktstiften 5 aus dem Material eines zwischen zwei Widerstandselementen 4 angeordneten Anschlusselements 3 verwendet werden.

### Bezugszeichenliste

- 1: Vorrichtung
- 2: Widerstandsanordnung
- 3: Anschlusselement
- 4: Widerstandselement
- 5: Kontaktstift
- 51: Absatz
- 6: Überstand
- 7: laterale Verbreiterung
- 8: Leiterplatte
- 9: Durchgangsbohrung
- 11: Stempel
- 12: Negativform
- 13: Aussparung

- H: Höhe
- T: Dicke
- s: Abstand

## Patentansprüche

1. Verfahren zur Herstellung einer Vorrichtung (1) zur Messung von Stromstärken mittels einer Widerstandsanordnung (2), wobei das Verfahren folgende Schritte umfasst:
a) Bereitstellen einer Widerstandsanordnung (2) umfassend mindestens zwei Anschlusselemente (3) und mindestens ein in Bezug auf die Richtung des Stromflusses zwischen den Anschlusselementen (3) angeordnetes Widerstandselement (4), wobei das mindestens eine Widerstandselement (4) einerseits und die Anschlusselemente (3) andererseits aus unterschiedlichen, elektrisch leitenden Materialien bestehen,
b) Formen mindestens eines Kontaktstifts (5) aus dem Material mindestens eines Anschlusselements (3),
c) Positionieren einer Leiterplatte (8), welche mindestens eine Leiterbahn und mindestens eine Durchgangsbohrung (9) aufweist, auf der Widerstandsanordnung (2) derart, dass der mindestens eine Kontaktstift (5) durch die Durchgangsbohrung (9) hindurch ragt und auf der der Widerstandsanordnung (2) abgewandten Seite der Leiterplatte (8) einen Überstand (6) über die Leiterplatte (8) aufweist,
d) Laterales Verbreitern des Kontaktstifts (5) zumindest im Bereich seines Überstands (6) durch Verformung des Materials, so dass die Leiterplatte (8) auf der Widerstandsanordnung (2) mechanisch fixiert wird,
e) Herstellen einer elektrisch leitenden Verbindung zwischen dem Kontaktstift (5) und mindestens einer Leiterbahn der Leiterplatte (8).

2. Verfahren nach Anspruch 1, **dadurch gekennzeichnet, dass** das Formen des Kontaktstifts (5) in Verfahrensschritt b) durch einen Prägeschritt oder durch Fließpressen erfolgt.

3. Verfahren nach Anspruch 2, **dadurch gekennzeichnet**, **dadurch gekennzeichnet, dass** zur Formgebung des Kontaktstifts (5) eine Negativform (12) mit mindestens einer der Kontur des Kontaktstifts (5) entsprechenden Aussparung (13) verwendet wird.

4. Verfahren nach einem der vorstehenden Ansprüche, **dadurch gekennzeichnet, dass** das laterale Verbreitern des Kontaktstifts (5) in Verfahrensschritt d) durch einen Stauchvorgang, durch Prägen, durch Verstemmen oder durch Umbördeln erfolgt.

5. Verfahren nach einem der vorstehenden Ansprüche, **dadurch gekennzeichnet, dass** das laterale Verbreitern des Kontaktstifts (5) in Verfahrensschritt d) durch Erwärmen des Materials mittels Ultraschall oder mittels eines Lasers unterstützt wird.

6. Verfahren nach einem der vorstehenden Ansprüche, **dadurch gekennzeichnet, dass** das Herstellen der elektrisch leitenden Verbindung in Verfahrensschritt e) durch das laterale Verbreitern des Kontaktstifts (5) im Bereich seines Überstands (6) in Verfahrensschritt d) erfolgt.

7. Verfahren nach einem der vorstehenden Ansprüche, **dadurch gekennzeichnet, dass** das Herstellen der elektrisch leitenden Verbindung in Verfahrensschritt e) erfolgt, indem der Kontaktstift (5) derart verformt wird, dass er die Innenoberfläche der Durchgangsbohrung (9) der Leiterplatte (8) kontaktiert.

8. Vorrichtung (1) zur Messung von Stromstärken umfassend eine Widerstandsanordnung (2) und eine mit der Widerstandsanordnung (2) mechanisch und elektrisch verbundene Leiterplatte (8), wobei die Widerstandsanordnung (2) mindestens zwei Anschlusselemente (3) und mindestens ein zwischen den Anschlusselementen (3) angeordnetes Widerstandselement (4) umfasst, wobei das mindestens eine Widerstandselement (4) einerseits und die Anschlusselemente (3) andererseits aus unterschiedlichen, elektrisch leitenden Materialien bestehen, und wobei die Leiterplatte (8) mindestens eine Leiterbahn und mindestens eine Durchgangsbohrung (9) aufweist, wobei die Widerstandsanordnung (2) mindestens einen Kontaktstift (5) aufweist, durch den die Widerstandsanordnung (2) mit der Leiterplatte (8) verbunden ist, indem sich der Kontaktstift (5) durch die Durchgangsbohrung (9) der Leiterplatte (8) hindurch erstreckt und auf der von der Widerstandsanordnung (2) abgewandten Seite der Leiterplatte (8) eine laterale Verbreiterung (7) aufweist, durch welche die Leiterplatte (8) auf der Widerstandsanordnung (2) mechanisch fixiert ist,
**dadurch gekennzeichnet, dass** H
der mindestens eine Kontaktstift (5) monolithisch mit einem der Anschlusselemente (3) verbunden und aus dem Material des Anschlusselements (3) herausgearbeitet ist.

9. Vorrichtung (1) nach Anspruch 8, **dadurch gekennzeichnet, dass** der mindestens eine Kontaktstift (5) mittels seiner lateralen Verbreiterung (7) in elektrischem Kontakt mit mindestens einer Leiterbahn der Leiterplatte (8) steht.

10. Vorrichtung (1) nach Anspruch 8 oder 9, **dadurch gekennzeichnet, dass** der mindestens eine Kontaktstift (5) in elektrischem Kontakt mit der Innenoberfläche der Durchgangsbohrung (9) der Leiterplatte (8) steht.

11. Vorrichtung (1) nach einem der Ansprüche 8 bis 10, **dadurch gekennzeichnet, dass** der mindestens eine Kontaktstift (5) einen Absatz (51) aufweist, auf dem die Leiterplatte (8) in einer Weise aufliegt, dass die Leiterplatte (8) von dem Anschlusselement (3) beabstandet ist.

12. Vorrichtung (1) nach einem der Ansprüche 8 bis 11, **dadurch gekennzeichnet, dass** die Oberfläche des mindestens einen Kontaktstifts (5) eine metallische Beschichtung, insbesondere eine zinn-, silber- oder nickelhaltige Beschichtung, aufweist.

## Claims

1. Method for producing an apparatus (1) for measuring current strengths by means of a resistor arrangement (2), wherein the method comprises the following steps:
a) providing a resistor arrangement (2) comprising at least two connection elements (3) and at least one resistor element (4) which is arranged with respect to the direction of the current flow between the connection elements (3), wherein the at least one resistor element (4), on the one hand, and the connection elements (3), on the other hand, comprise different, electrically conductive materials,
b) forming at least one contact pin (5) made from the material of at least one connection element (3),
c) positioning a printed circuit board (8) which has at least one strip conductor and at least one through-hole (9) on the resistor arrangement (2) in such a manner that the at least one contact pin (5) protrudes through the through-hole (9) and at the side of the printed circuit board facing away from the resistor arrangement (2) has an overhang (6) over the printed circuit board (8),
d) laterally expanding the contact pin (5) at least in the region of the overhang (6) thereof by means of deformation of the material so that the printed circuit board (8) is mechanically fixed to the resistor arrangement (2),
e) producing an electrically conductive connection between the contact pin (5) and at least one strip conductor of the printed circuit board (8).

2. Method according to claim 1, **characterised in that** the forming of the contact pin (5) in the method step (b) is carried out by means of a stamping step or by means of extrusion.

3. Method according to claim 2, **characterised in that**, in order to form the contact pin (5), a negative mould (12) having at least one recess (13) which corresponds to the contour of the contact pin (5) is used.

4. Method according to any one of the preceding claims, **characterised in that** the lateral expansion of the contact pin (5) in the method step (d) is carried out by means of a compression operation, by means of stamping, by means of caulking or by means of beading.

5. Method according to any one of the preceding claims, **characterised in that** the lateral expansion of the contact pin (5) in the method step (d) is supported by heating the material by means of ultrasound or by means of a laser.

6. Method according to any one of the preceding claims, **characterised in that** the production of the electrically conductive connection in the method step e) is carried out by means of the lateral expansion of the contact pin (5) in the region of the overhang (6) thereof in the method step (d).

7. Method according to any one of the preceding claims, **characterised in that** the production of the electrically conductive connection in the method step e) is carried out by the contact pin (5) being deformed in such a manner that it contacts the inner surface of the through-hole (9) of the printed circuit board (8).

8. Apparatus (1) for measuring current strengths, comprising a resistor arrangement (2) and a printed circuit board (8) which is mechanically and electrically connected to the resistor arrangement (2), wherein the resistor arrangement (2) comprises at least two connection elements (3) and at least one resistor element (4) which is arranged between the connection elements (3), wherein the at least one resistor element (4), on the one hand, and the connection elements (3), on the other hand, comprise different electrically conductive materials, and wherein the printed circuit board (8) has at least one strip conductor and at least one through-hole (9), wherein the resistor arrangement (2) has at least one contact pin (5) by means of which the resistor arrangement (2) is connected to the printed circuit board (8) by the contact pin (5) extending through the through-hole (9) of the printed circuit board (8) and at the side of the printed circuit board (8) facing away from the resistor arrangement (2) having a lateral expansion (7) by means of which the printed circuit board (8) is mechanically fixed to the resistor arrangement (2), **characterised in that** the at least one contact pin (5) is connected in a monolithic manner to one of the connection elements (3) and is formed from the material of the connection element (3).

9. Apparatus (1) according to claim 8, **characterised in that** the at least one contact pin (5) by means of the lateral expansion (7) thereof is in electrical contact with at least one strip conductor of the printed circuit board (8).

10. Apparatus (1) according to claim 8 or 9, **characterised in that** the at least one contact pin (5) is in electrical contact with the inner surface of the through-hole (9) of the printed circuit board (8).

11. Apparatus (1) according to any one of claims 8 to 10, **characterised in that** the at least one contact pin (5) has a shoulder (51) on which the printed circuit board (8) is positioned in such a manner that the printed circuit board (8) is spaced apart from the connection element (3).

12. Apparatus (1) according to any one of claims 8 to 11, **characterised in that** the surface of the at least one contact pin (5) has a metal coating, in particular a tin-containing, silver-containing or nickel-containing coating.

## Revendications

1. Procédé de fabrication d'un dispositif (1) destiné à mesurer des intensités de courant au moyen d'un agencement de résistance (2), dans lequel le procédé comprend les étapes suivantes :
a) fourniture d'un agencement de résistance (2) comprenant au moins deux éléments de raccordement (3) et au moins un élément de résistance (4) agencé entre les éléments de raccordement (3) par rapport à la direction du flux de courant, dans lequel le au moins un élément de résistance (4) d'une part et les éléments de raccordement (3) d'autre part sont composés de matériaux électro-conducteurs différents,
b) formation d'au moins une broche de contact (5) dans le matériau d'au moins un élément de raccordement (3),
c) positionnement d'une plaque conductrice (8), laquelle présente au moins une piste conductrice et au moins un alésage traversant (9), sur l'agencement de résistance (2) de sorte que la au moins une broche de contact (5) dépasse à travers l'alésage traversant (9) et présente une saillie (6) par-dessus la plaque conductrice (8) sur le côté, opposé à l'agencement de résistance (2), de la plaque conductrice (8),
d) élargissement latéral de la broche de contact (5) au moins dans la région de sa saillie (6) par déformation du matériau de sorte que la plaque conductrice (8) soit mécaniquement fixée sur l'agencement de résistance (2),
e) création d'une liaison électro-conductrice entre la broche de contact (5) et au moins une piste conductrice de la plaque conductrice (8).

2. Procédé selon la revendication 1, **caractérisé en ce que** la formation de la broche de contact (5) à l'étape de procédé b) se réalise par une étape d'estampage ou par extrusion.

3. Procédé selon la revendication 2, **caractérisé en ce qu'**un moule négatif (12) avec au moins un évidement (13) correspondant au contour de la broche de contact (5) est utilisé pour le façonnage de la broche de contact (5).

4. Procédé selon l'une des revendications précédentes, **caractérisé en ce que** l'élargissement latéral de la broche de contact (5) à l'étape de procédé d) se réalise par un processus de refoulement, par estampage, par matage ou par bordage.

5. Procédé selon l'une des revendications précédentes, **caractérisé en ce que** l'élargissement latéral de la broche de contact (5) à l'étape de procédé d) est soutenu par réchauffement du matériau au moyen d'ultrasons ou au moyen d'un laser.

6. Procédé selon l'une des revendications précédentes, **caractérisé en ce que** la création de la liaison électro-conductrice à l'étape de procédé e) se réalise par l'élargissement latéral de la broche de contact (5) dans la région de sa saillie (6) à l'étape de procédé d).

7. Procédé selon l'une des revendications précédentes, **caractérisé en ce que** la création de la liaison électro-conductrice à l'étape de procédé e) se réalise en déformant la broche de contact (5) de sorte qu'elle entre en contact avec la surface intérieure de l'alésage traversant (9) de la plaque conductrice (8).

8. Dispositif (1) destiné à mesurer des intensités de courant comprenant un agencement de résistance (2) et une plaque conductrice (8) mécaniquement et électriquement reliée à l'agencement de résistance (2), dans lequel l'agencement de résistance (2) comprend au moins deux éléments de raccordement (3) et au moins un élément de résistance (4) agencé entre les éléments de raccordement (3), dans lequel le au moins un élément de résistance (4) d'une part et les éléments de raccordement (3) d'autre part sont composés de matériaux électro-conducteurs différents, et dans lequel la plaque conductrice (8) présente au moins une piste conductrice et au moins un alésage traversant (9), dans lequel l'agencement de résistance (2) présente au moins une broche de contact (5) à travers laquelle l'agencement de résistance (2) est relié à la plaque conductrice (8) en ce que la broche de contact (5) s'étend à travers l'alésage traversant (9) de la plaque conductrice (8) et présente un élargissement (7) latéral sur le côté, opposé à l'agencement de résistance (2), de la plaque conductrice (8), par lequel la plaque conductrice (8) est mécaniquement fixée sur l'agencement de résistance (2),
**caractérisé en ce que** la au moins une broche de contact (5) est reliée de façon monolithique à l'un des éléments de raccordement (3) et est ébauchée dans le matériau de l'élément de raccordement (3).

9. Dispositif (1) selon la revendication 8, **caractérisé en ce que** la au moins une broche de contact (5) se trouve en contact électrique avec au moins une piste conductrice de la plaque conductrice (8) au moyen de son élargissement (7) latéral.

10. Dispositif (1) selon la revendication 8 ou 9, **caractérisé en ce que** la au moins une broche de contact (5) se trouve en contact électrique avec la surface intérieure de l'alésage traversant (9) de la plaque conductrice (8).

11. Dispositif (1) selon l'une des revendications 8 à 10, **caractérisé en ce que** la au moins une broche de contact (5) présente un épaulement (51) sur lequel repose la plaque conductrice (8) de manière à ce que la plaque conductrice (8) soit espacée de l'élément de raccordement (3).

12. Dispositif (1) selon l'une des revendications 8 à 11, **caractérisé en ce que** la surface de la au moins une broche de contact (5) présente un revêtement métallique, en particulier un revêtement contenant de l'étain, de l'argent ou du nickel.
